(19) **Europäisches Patentamt**

**European Patent Office**

**Office européen des brevets**

(11) **EP 0 974 845 A1**

(12) **EUROPEAN PATENT APPLICATION**

(43) Date of publication:
26.01.2000 Bulletin 2000/04

(51) Int. Cl.[7]: **G01R 1/073**

(21) Application number: **98610023.8**

(22) Date of filing: **08.07.1998**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Petersen, Christian, Leth**<br>  **DK-2830 Virum (DK)**<br>• **Grey, Francois**<br>  **DK-1062 Copenhagen (DK)** |
| (71) Applicant:<br>**Petersen, Christian Leth**<br>**2830 Virum (DK)** | (74) Representative:<br>**Kjerrumgaard, Bent et al**<br>**Budde, Schou & Ostenfeld A/S**<br>**Bredgade 41**<br>**P.O. Box 1183**<br>**1011 Copenhagen K (DK)** |

(54) **Apparatus for testing electric properties using a multi-point probe**

(57)     An object of the present invention is to provide a novel testing probe allowing the testing of electronic circuits of a smaller dimension as compared to the prior art testing technique. A particular advantage of the present invention is related to the fact that the novel testing technique involving a novel multi-point probe (12,14,16,18) allows the probe to be utilised for establishing a reliable contact between any testing pin or testing tip and a specific location of a test sample, as the testing probe according to the present invention includes individually bendable or flexible testing pins (14,18). A particular feature of the present invention relates to the fact that the testing probe according to the present invention may be produced in a process compatible with the production of electronic circuits, allowing measurement electronics to be integrated on the testing probe, and allowing for tests to be performed on any device fabricated by any appropriate circuit technology involving planar technique, CMOS technique, thick-film technique or thin-film technique and also LSI and VLSI production techniques.

**EP 0 974 845 A1**

Printed by Xerox (UK) Business Services
2.16.7/3.6

## Description

### Field of the invention

The present invention generally relates to the technique of testing electric properties on a specific location of a test sample and in particular the technique of probing and analysing semiconductor integrated circuits for example of LSI and VLSI complexity.

### Description of the related art

The most commonly used technique of testing the electric properties of a test sample involves the generation of resistivity or carrier concentration profiles of the surface of a processed semiconductor wafer by the utilisation of a four point probe as described in published international patent application WO 94/11745. Furthermore, see for example S.M. Sze, Semiconductor devices — Physics and Technology, Wiley New York (1985).

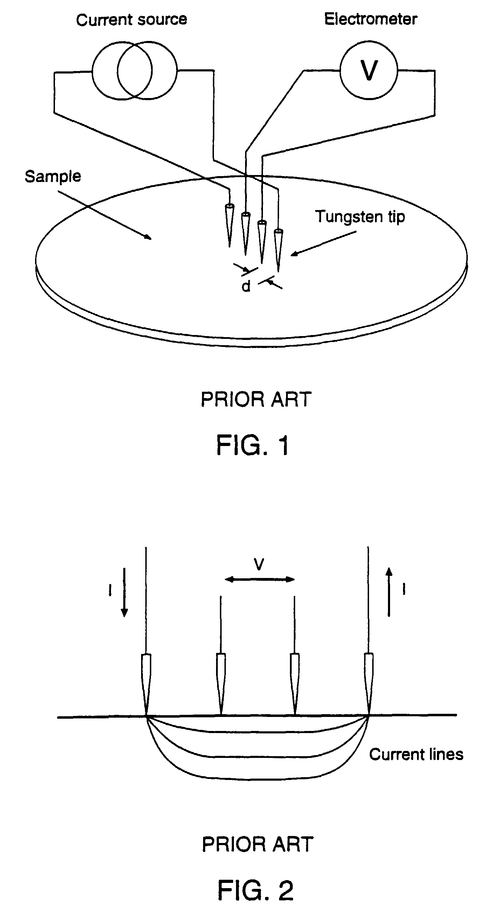

As shown generally in figure 1, the conventional four point probe technique typically has the points positioned in an in-line configuration. By applying a current to the two peripheral points as shown in detail in figure 2, a voltage can be measured between the two inner points of the four point probe. Thus the electric resistivity of the test sample can be determined through the equation

$$\rho = c \cdot (V/I),$$

wherein $V$ is voltage measured between inner points, wherein $I$ is current applied to the peripheral points and, wherein $c$ is a geometry factor depending on the surface contact separation $d$ and the dimensions of the test sample. Several schemes for calculating the correction factors have been developed, see F.M. Smits, *Measurement of Sheet Resistivities with the Four-Point Probe,* Bell System Technical J. 37, 711 (1958), EP 0 299 875 B1, and J. Shi and Y. Sun, *New method for calculation of the correction factors for the measurement of sheet resistivity of a square sample with a square four-point probe,* Rev. Sci. Instrum. 68 1814 (1997).

The four-point probe generally consists of four tungsten or solid tungsten carbide tips positioned into contact with a test sample, being for example a semiconductor wafer. An external positioning system places the four-point probe into physical contact with the semiconductor wafer by moving the four-point probe in a perpendicular motion relative to the wafer surface. Pressure perpendicular to the wafer surface has to be applied to the four-point probe, in order to insure, that all four points obtain physical contact with for example an uneven wafer surface. Hence the pressure from the tips on the surface varies between the tips. The tips are separated by a distance **d**, shown in figure 1, typically in the order of 0.5 mm.

An alternative to the above described four-point probe is the SR (Spreading Resistance) probe, described in US Patent No. 5,347,227. The SR probe consists of two probe tips situated on one cantilever arm. The SR probe is brought into physical contact with wafer surface by an external positioning system, while monitoring the applied pressure such as to accurately control the physical contact to the uneven surface of a semiconductor wafer. However, since the tips are situated on the same cantilever beam the pressure monitored while monitoring the maximum pressure which may possibly leave one tip with an inferior physical contact.

Furthermore, apart from the above described limitations as to establishing contact with the surface of the test sample to be tested the prior art probes possess limitations as to miniaturisation of the testing technique as the probes hitherto known limit the maximum spacing between any two tips to a dimension in the order of 0.5 mm due to the production technique involving mechanical positioning and arresting of the individual testing pins or testing tips, in particular as far as the four-point probes are concerned, and as far as the SR-probes are concerned exhibit extreme complexity as far as the overall structure is concerned and also certain drawbacks as far as the utilisation of the SR-probe due to the overall structure of the SR-probe.

It appears that no technique is currently available for obtaining the electric properties of individual devices on semiconductor wafers, without possible destruction of device junctions . Thus, there is a need for a device which can perform high resolution electric properties measurements on individual devices, further minimising the possibility of destruction of semiconductor wafer surfaces.

An object of the present invention is to provide a novel testing probe allowing the testing of electronic circuits of a smaller dimension as compared to the prior art testing technique and in particular of providing a testing probe allowing a spacing between testing pins less than 0.5 mm such as in the order of 5 µm e.g. 1-10 µm or even smaller spacing.

A particular advantage of the present invention is related to the fact that the novel testing technique involving a novel multi-point probe allows the probe to be utilised for establishing a reliable contact between any testing pin or testing tip and a specific location of the test sample, as the testing probe according to the present invention includes individually bendable or flexible testing pins.

A particular feature of the present invention relates to the fact that the testing probe according to the present invention may be produced in a process compatible with the production of electronic circuits, allowing measurement electronics to be integrated on the testing probe, and allowing for tests to be performed on any device fabricated by any appropriate circuit technology involving planar technique, CMOS technique, thick-film technique or thin-film technique and also LSI and VLSI production techniques.

The above object, the above advantage and the above feature together with numerous other objects, advantages and features which will be evident from the below detailed description of a preferred embodiment of the present invention is according to a first aspect of the present invention obtained by a multi-point probe for testing electric properties on a specific location of a test sample, comprising:

(a) a supporting body;
(b) a plurality of conductive probe arms positioned in co-planar relationship with surface of said supporting body, and freely extending from said supporting body, giving individually flexible motion of said plurality of conductive probe arms; and
(c) said conducting probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body.

According to the basic realisation of the present invention, the multi-point probe according to the first aspect of the present invention is implemented in accordance with the technique of producing electronic circuits, in particular involving planar techniques as the probe is produced from a supporting body, originating from a wafer body on which a plurality of conductive probe arms are produced involving deposition, accomplished by any technique known in the art, such as chemical vapour deposition (CVD), plasma enhanced CVD (PECVD), electron cyclotron resonance (ECR) or sputtering, etching or any other production technique, for example high resolution lithographic methods such as electron-beam lithography, atomic force microscopy (AFM) lithography or laser lithography, whereupon a part of the original supporting body is removed through mechanical grinding or etching producing the freely extending conducting probe arms characteristic to the present invention constituting the test pins of multi-point probes according to the first aspect of the present invention.

The above part, which is removed from the original wafer body, producing the body supporting the conductive probe arms may constitute a minor part or a major part of the original wafer body and, the supporting body may according to alternative embodiments of the multi-point probe according to the present invention dimensionally constitute a minor part or a major part as compared to the freely extending part of the conductive probe arms.

The conductive probe arms characteristic to the multi-point probe according to the first aspect of the present invention according to the basic realisation of the present invention allow the contacting of the multi-point probe in an angular positioning of the conductive probe arms in relation to the surface of the test sample to be tested as distinct from the above described four-point probe, which is moved perpendicularly in relation to the surface of the test sample. The angular orientation of the conductive probe arms of the multi-point probe allows the flexible and elastically bendable conductive probe arms to contact any specific and intentional location of the test sample and establish a reliable electrical contact with the location in question.

The technique characteristic to the present invention of establishing the contact between the multi-point probe and the test locations of the test sample by utilising an angular positioning of the conductive probe arms in relation to the test sample for contacting in a bending or flexing of the conducting probe arms prevents the probe arms from mechanically destroying or deteriorating the test sample to be tested, which may be of crucial importance in specific applications such as LSI and VLSI circuitry.

As distinct from the prior art four-point probe arm, the multi-point probe according to the present invention including a plurality of conductive probe arms may be configured in any appropriate configuration due to the utilisation of the production technique, allowing the conducting probe arms to be orientated in any mutual orientation in relation to one another and further in relation to the supporting body for complying with specific requirements such as a specific test sample to be tested. In this context, the particular feature of the present invention, namely the possibility of utilising a production technique compatible with the techniques used for producing electronic circuits, allows the multi-point probe to be readily configured in accordance with specific requirements through the utilisation of existing CAD/CAM techniques for microsystems. However, according to the presently preferred embodiment of the multi-point probe according to the first aspect of the present invention, the plurality of conductive probe arms are unidirectional constituting a plurality of parallel free extensions of the supporting body.

The possibility discussed above, of configuring the multi-point probe according to the first aspect of the present invention in accordance with specific requirements and, in particular, specific configurations or geometry of the electronic circuit to be tested constituting the test sample allows the conductive probe arms to be positioned on one surface of the supporting body or, alternatively, in accordance with an alternative embodiment on two opposing surfaces of the supporting body or even on non-opposing surfaces of the supporting body e.g. on neighbouring surfaces of a cubic supporting body.

The plurality of conductive probe arms on one surface of the multi-point probe according to the first aspect of the present invention consists of a multiple of 2, ranging from at least 2 conductive probe arms to 64 conductive probe arms, having four conductive probe arms positioned on one surface as the presently preferred embodiment. Application of a test signal to the surface of the test sample between the two peripherally positioned conductive probe arms provides a resultant test signal between the two inner conductive probe arms, including information of the electric properties of the test sample.

The plurality of conductive probe arms of the multi-point probe according to the first aspect of the present invention have a rectangular cross section, with the dimensions defined as : width being parallel to the plane of the surface of the supporting body of the multi-point probe, depth being perpendicular to the plane of the surface of the supporting body of the multi-point probe and, length being the length of the conductive probe arms extending freely from the supporting body of the multi-point probe. The dimension ratios of the plurality of conductive probe arms comprises ratios such as : length to width within the range 500:1 to 5:1, including ratios 50:1 and 10:1, having the ratio of 10:1 as the presently preferred embodiment, width to depth ratio within the range of 20:1 to 2:1, having the ratio of 10:1 as the presently preferred embodiment. The length of the plurality of probe arms is in the range of 20μm to 2mm, having a length of 200μm as the presently preferred embodiment. The separation of distal end-points of the conductive probe arms ranges from 1μm to 1mm, having 20μm, 40μm and 60μm as the presently preferred embodiments. However, as previously described the dimensions of the multi-point probe according to the first aspect of the present invention varies as a function of the current state of the art in production technology and are therefore not a limitation to the present invention.

The distal end-points of the plurality of conductive probe arms comprise a variety of optional shapes in continuation of the end of the length opposing the supporting body of the multi-point probe according to the first aspect of the present invention. The continuation of the length of the freely extending conductive probe arms include shapes as pointed distal end-points, tapered distal end-points or enlarged circular, elliptic or orthogonal squared distal ends or combinations thereof The elaboration of the distal end-points of the plurality of the conductive probe arms allows for optimisation of measurements of electric properties of the test sample, that being resistive, capacitive or inductive electric properties of the test sample at frequencies ranging from DC to RF including frequencies in the LF range and the HF range.

The multi-point probe according to the first aspect of the present invention further comprises, in accordance with specific requirements, a plurality of conductive electrodes situated on co-planar, elevated or undercut areas between the plurality of conductive probe arms on the supporting body. The plurality of conductive electrodes are suitable for active guarding of the plurality of conductive probe arms to significantly reduce leakage resistance and, consequently, increase the measuring accuracy of the present invention.

The material of the supporting body of the multi-point probe according to the first aspect of the present invention comprises ceramic materials or semiconducting materials such as Ge, Si or combinations thereof Use of the semiconducting materials Ge, Si or combinations thereof allows for the microfabrication technology in the manufacturing process of the multi-point probe, hence benefiting from the advantages of the microfabrication technology.

The conductive layer on the top surface of the plurality of conductive probe arms and the conductive layer of the plurality of conductive electrodes on the multi-point probe according to the first aspect of the present invention is made by conducting materials such as Au, Ag, Pt, Ni, Ta, Ti, Cr, Cu, Os, W, Mo, Ir, Pd, Cd, Re, conductive diamond, metal silicides or any combinations thereof.

The above object, the above advantage and the above feature, together with numerous other objects, advantages and features which will be evident from the below detailed description of a presently preferred embodiment of the present invention, are obtained, according to a second aspect of the present invention, by a multi-point testing apparatus for testing electric properties on a specific location of a test sample, comprising:

(i) means for receiving and supporting said test sample;
(ii) electric properties testing means including electric generator means for generating a test signal and electric measuring means for detecting a measuring signal;
(iii) A multi-point probe, comprising:

(a) a supporting body;
(b) a plurality of conductive probe arms positioned in co-planar relationship with surface of said supporting body, and freely extending from said supporting body, giving individually flexible motion of said plurality of conductive probe arms; and
(c) said conducting probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
(d) said multi-point probe communicating with said electric properties testing means; and

(iv) reciprocating means for moving said multi-point probe relative said test sample so as to cause said conductive probe arms to be contacted with said specific location of said test sample for performing said testing of electric properties thereof.

The multi-point testing apparatus according to the second aspect of the present invention basically includes a multi-point probe according to the first aspect of the present invention, which multi-point probe, constituting a component of the multi-point testing apparatus according to second aspect of the present invention, may be implemented in accordance with any of the above features of the multi-point probe according to the first aspect of the present invention. Furthermore, the multi-point testing apparatus according to the second aspect of the present invention includes electric properties testing means for testing the test sample comprising an electric generator means providing a test signal to the surface of the test sample, that being current or voltage, pulsed signal or signals, DC or AC having sinusoidal, squared, triangled signal contents or combinations thereof, ranging from LF to RF including HF, in accordance with specific requirements such as measurements of resistance, inductance, capacitance, slew rate, unity gain bandwidth and 3dB bandwidth. The electric properties testing means further comprises an electric measuring means providing facilities for detecting a measuring signal of the above described test signal types and frequency ranges, and providing extensive electric properties testing information and including functionalities as Fast Fourier Transformation (FFT), phase lock and real time visualisation of measured test signal. The electric properties testing means features probing means for probing of the test sample, in accordance with specific requirements, so as to perform the link between the surface of the test sample and the electric properties testing means.

The multi-point testing apparatus according to the second aspect of the present invention also includes reciprocating means for holding a multi-point probe according to the first aspect of the present invention, and positioning of the multi-point probe according to the first aspect of the present invention relative to the test sample so as to cause the conductive probe arms to obtain physical contact with a specific location on the surface of the test sample for performing the testing of the electric properties, and for recording of the specific location of the multi-point probe according to the first aspect of the present invention relative to the test sample, having a resolution of 0.1μm or even smaller in all spatial directions. An object of having full maneuvability in all spatial directions, that being coplanar to the surface of the test sample or perpendicular to the surface of the test sample, is to allow for multiple point measurements utilising one calibrated multi-point probe according to the first aspect of the present invention on a full surface of a test sample, hence avoiding inaccuracies due to a multiple of calibration discrepancies. The maneuvability includes angular movements along an axis parallel to surface of the test sample, providing an angle between the surface of the test sample and the length of the conductive probe arms on the multi-point probe according to the first aspect of the invention, thus utilising the flexibility of the conductive probe arms to insure against possible destruction or deterioration of devices on the surface of the test sample, and along an axis perpendicular to the surface of the test sample providing a 360° rotation of the multi-point probe according to the first aspect of the present invention enabling measurements on devices on the surface of the test sample having any mutual relative co-planar angular positions.

The multi-point testing apparatus according to the second aspect of the present invention further includes means for sensing physical contact between the surface of the test sample and the multiple of conductive probe arms of the multi-point probe according to the first aspect of the present invention insuring non-destructive testing of the test sample and hence avoiding the destruction of possible devices on the surface of the test sample.

The above object, the above advantage and the above feature, together with numerous other objects, advantages and features which will be evident from the below detailed description of a presently preferred embodiment of the present invention, are obtained by a third aspect of the present invention, by a method of producing a multi-point probe comprising the following steps:

(i) producing a wafer body,
(ii) producing a plurality of conductive probe arms positioned in co-planar and facial relationship with said wafer body, and
(iii) removing a part of said wafer body for providing said conductive probe arms freely extending from said non-removed part of said wafer body constituting a supporting body from which said conductive probe arms extend freely.

The method of producing the multi-point probe in accordance with a third aspect of the present invention may involve any relevant production technique allowing the production of the freely extending conductive probe arms extending freely in relation to the supporting body. Techniques of relevance and interest are based on semiconductor microfabrication technology, thick-film technique, thin-film technique or combinations thereof.

**Brief description of the drawings**

Figure 1, provides an overall illustration of the conventional four-point probe measurement technique on a test sample.

Figure 2, shows a detailed illustration of the measurement technique depicted in figure 1;

Figure 3, depicts the substrate after patterning a deposited support layer;

Figure 4, illustrates the formation of the cantilevers by removal of part of the substrate;

Figure 5, depicts the etching of the substrate to undercut the pattern in the support layer;

Figure 6, depicts the deposition of an electrically conducting layer;

Figure 7, depicts a set-up for measuring a test sample using a multi-point probe made in accordance with the present invention;

Figure 8, illustrates a set-up having a multi-point probe made in accordance with the present invention mounted on an optical microscope;

Figure 9, pictures a detachable multi-point probe in a semiconducting wafer.

Figure 10, shows a principal diagram of the circuit used for performing measurements, comprising an electrometer and a current source.

**Detailed description of the preferred embodiments.**

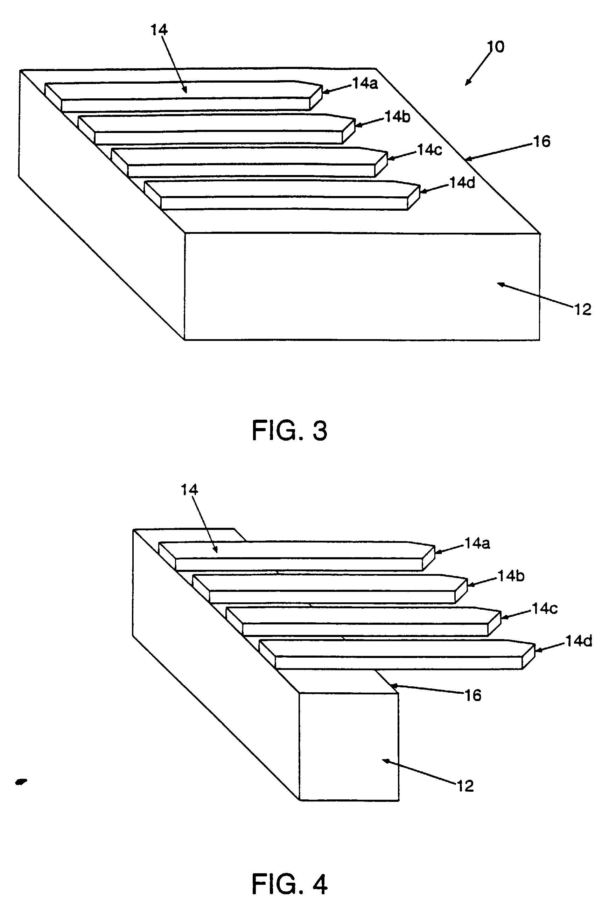

A preferred embodiment is directed toward making a multi-point probe and is described with respect to figures 3-6.

Figure 3 shows a wafer **10**, for example a section of a semiconductor wafer, in intermediate state of fabrication. It shows a surface **16** of a substrate **12** covered by a support layer **14**, being electrically isolating, such as silicon oxide. The deposition of the support layer **14** can be accomplished by any technique known in the art, such as chemical vapour deposition (CVD), plasma enhanced CVD (PECVD), electron cyclotron resonance (ECR) or sputtering. As shown in figure 3, the support layer **14 i**s patterned and etched to form beams with tapered end-points **14a-d.** The beams are not limited to any particular form or symmetry; they can be of any geometry with suitable end-points.

The pattern is formed by forming a photoresist pattern (not shown in figure 3) which defines the four beams on the top surface of the support layer **14**. The photoresist pattern is formed by conventional photolithographic photoresist formation, exposure, development and removal techniques. The support layer is then etched using any technique known in the art, such as dry etching or wet etching, until the unmasked parts of the support layer **14** are removed from the top surface of the substrate.

In an alternative embodiment of the present invention the four beams or part of them can be defined using high resolution lithographic methods such as electron-beam lithography, atomic force microscopy (AFM) lithography or laser lithography.

Once the support layer has been patterned, the substrate is partially removed to release the patterned support layer, forming four cantilevers with sharpened end-points **14a-d**, as illustrated in figure 4.

In the preferred embodiment, the substrate is removed by depositing a protective layer (not shown in figure 4) of silicon nitride on top and bottom surface of the substrate **12**. Next, a photoresist pattern is formed on the bottom surface of the substrate by conventional photolithographic photoresist formation, exposure, development and removal techniques. The nitride layer is then removed in the unmasked areas on the bottom surface of the substrate using Reactive Ion Etch (RIE) in a plasma containing $SF_6$ and $O_2$ or similar reagents, and the substrate is etched using an etching chemistry comprising potassium hydroxide (KOH) or a similar chemistry until the freely extending probe arms are exposed. Then the protecting layer of nitride is removed from the top surface of the substrate using RIE, or using wet etching with a chemistry comprising phosphoric acid ($H_3PO_4$) or a similar chemistry.

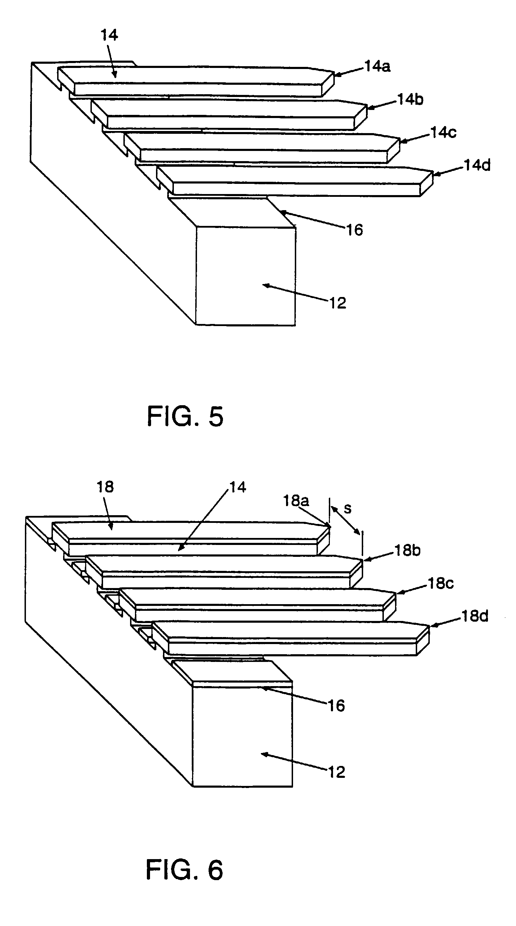

Figure 5, illustrates the etching of the substrate **12** to undercut the support layer **14**. In the preferred embodiment, this etching step is performed with a dry etching method, such as an isotropic RIE etch.

The final stage of fabrication is shown in figure 6, and involves the deposition of an electrically conducting layer **18** on the top surface of the wafer. The conducting layer is made of conducting materials like Au, Ag, Pt, Ni, Ta, Ti, Cr, Cu, Os, W, Mo, Ir, Pd, Cd, Re, conductive diamond, metal silicides or combinations thereof Alternatively the conducting layer can be made of a highly doped semiconducting material. The conducting layer can be deposited using electron-beam evaporation, or any other similar technique known in the art. Due to the undercutting of the support layer **14**, the electrically conducting layer will not create conducting paths between the four beams made in the support layer, and thus four isolated electrodes are formed on the top surface of the support beams, and thus points **18a-d** can be connected through the beams to an external positioning and measuring device (not shown in figure 6).

As shown in figure 6 the deposition of the conducting layer creates electrodes on the substrate. In a preferred embodiment these electrodes are used for active guarding of the conductive probe arms to significantly reduce leakage resistance and, consequently, increase the measuring accuracy of the invention.

Referring again to figure 6, in the present invention the minimum probe end-point separation **s** is approximately 1μm. The minimum probe end-point separation is however determined by the current state of the art in micro-fabrication technology and not any limitation of the present invention. Thus, as micro-fabrication technology produces smaller and smaller devices, the minimum probe end-point separation **s** can also be reduced.

In operation an external positioning device places a multi-point probe made according to the present invention into physical contact with the surface of the test sample. Once electrical contact between the surface of the test sample and all four conductive probe arms has been achieved, a current is applied to two of the conductive probe arms and a corresponding voltage is measured between the two other conductive arms. The method for applying the current and detecting the voltage can be any method known in the art.

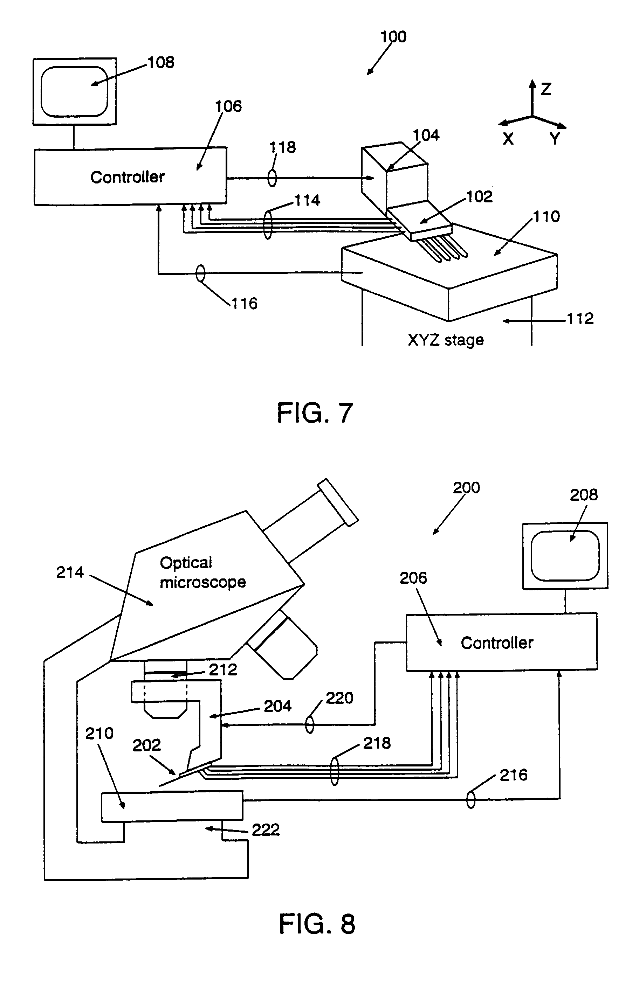

The preferred embodiment of the multi-point testing apparatus of the present invention is shown in figure 7. The figure depicts a multi-point testing apparatus **100**, a test sample **110** is mounted on a stage **112** with an XYZ positioning mechanism. This mechanism can be controlled automatically or manually. A multi-point probe made according to present invention **102** is mounted above the surface of the test sample on a probe holder **104** which can be moved in the Z direction with a resolution of 0.1μm or better. Optionally the probe holder **104** can be controlled with similar spatial resolution in the X and Y directions. The set-up **100** is similar to that of an AFM or a Scanning Tunnelling Microscope (STM). Connections **114** from the probe end-points are input to a controller **106**, which can move the multi-point probe with respect to the test sample **110**. Optionally a connection **116** from the test sample **110** can also be input to the controller **106**. The controller **106** can be a computer or a programmed micro-controller. By monitoring the four point resistance using the end-points of the four probe arms or the two point resistances between the end-points of the four probe arms and the test sample **110**, the controller **106** can move the multi-point probe towards the test sample until all end-points of the four probe arms are in physical contact with the test sample. By holding the multi-point probe having the probe arm lengths in an angle relative to the surface of the test sample **110**, smaller than perpendicular and larger than parallel, full individual probe arm flexibility is achieved, providing a safe mode of operation in regards to avoiding destruction of single devices on top surface of test sample. Then a measurement can be made of the test sample resistivity, and the controller **106** analyses the measured data and displays measurement information on display **108**. The controller **106** can the refract the multi-point probe, move the test sample **110** in the XY plane and repeat the procedure.

Figure 8 illustrates a similar apparatus **200** where the test sample stage consists of a XY positioned **222** on a standard optical microscope **214**. A multi-point probe made in accordance to the present invention **202** is placed on a probe holder **204**, which is mounted on a microscope objective **212**, allowing the operator to identify features on the test sample surface and perform four point probe measurements at these features. In this manner μm sized test sample features such as single microelectronic devices or polycrystalline grains can be probed in a controlled fashion. Similar to the previously described apparatus **100**, illustrated in figure 7, the four leads **218** from the probe are input to a controller **206** as well as a lead **216** connecting to the test sample; the controller outputs signals **220** controlling the movement of the probe holder, and the controller **206** analyses and presents the measurement data on display **208**.

### Example showing the usage of the multi-point probe.

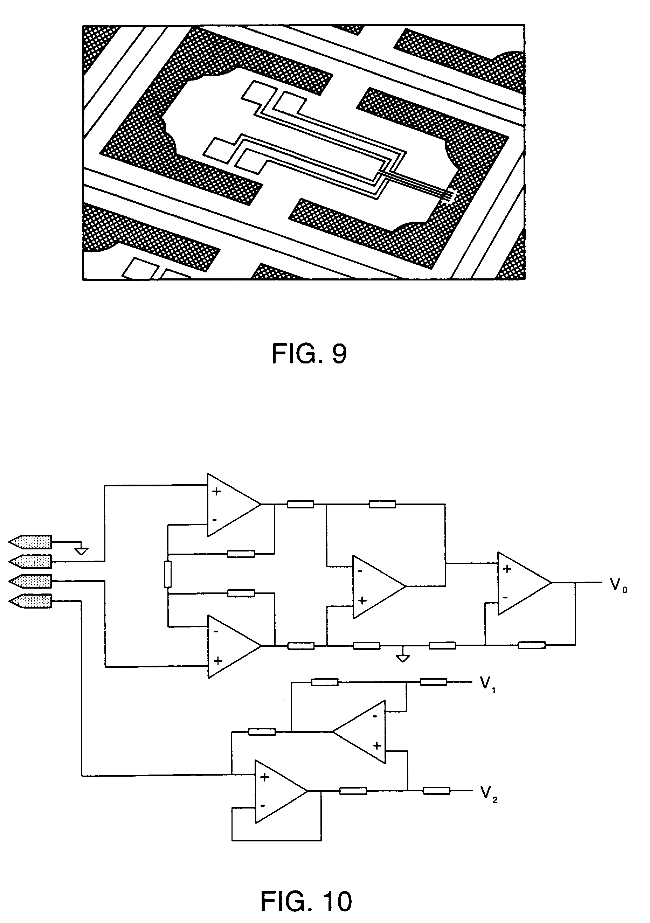

The probe chips (illustrated in figure 9) are broken out of the wafers and are mounted on ceramic dies (5mm x 10mm) with four big thick-film electrode pads, using epoxy. The conductive probe arms on the silicon chips are connected to the pads on the ceramic dies by bonding 25μm thick gold wires between them, using a Kulicke-Soffa wedge-bonding machine.

The ceramic chips are fixed mechanically and contacted electrically on an aluminium mount which is machined to fit around a microscope objective on a Karl-Suss probe station. The mount allows the conductive probe arms of the multi-point probe to be in focus in the middle of the field of view of the microscope. The test sample can then be moved into focus using the normal vertical stage of the microscope. When the test sample is in focus the multi-point probe will contact the test sample and a measurement can be performed. This set-up is similar to the general illustration in figure 8.

Electronics consisting of an electrometer and a current source is built into the aluminium mount to minimise the distance between the probe and the electronics. This keeps the noise in the measurements at a minimum. The principal diagram of the circuit is shown in figure 10. The two inner conductive probe arms of the multi-point probe are connected to an electrometer (an instrumentation amplifier) with an input impedance of more than 10GΩ and an amplification factor of 5000. The peripheral two conductive probe arms of the probe are connected to the current source (a differential voltage to current converter) which delivers an adjustable output in the range of 10nA to 1μA. The current output is proportional to the voltage difference V1-V2. These voltages are generated externally by a computer equipped with a digital to analogue converter. The same computer detects the output voltage Vo of the electrometer through an attached analogue to digital converter. The circuit is powered by batteries in order to make it float with respect to ground.

A measurement is performed by sampling the voltage of the electrometer for both polarities of the current, taking the average of the two values. This averaging procedure is useful for eliminating thermal drift in the electronics.

**Claims**

1. A multi-point probe for testing electric properties on a specific location of a test sample, comprising:

    (a) a supporting body;
    (b) a plurality of conductive probe arms positioned in co-planar relationship with surface of said supporting body, and freely extending from said supporting body, giving individually flexible motion of said plurality of conductive probe arms; and
    (c) said conducting probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body.

2. The multi-point probe according to claim 1, wherein said plurality of conductive probe arms are unidirectional, constituting a plurality of parallel free extensions of said supporting body.

3. The multi-point probe according to claim 1-2, wherein said plurality of conductive probe arms are situated on one surface of said supporting body.

4. The multi-point probe according to claim 1-2, wherein said plurality of conductive probe arms are situated on two opposing surfaces of said supporting body.

5. The multi-point probe according to claim 1-4, wherein said plurality of conductive probe arms are in a multiple of 2, ranging from at least 2 said conductive probe arms to 64 said conductive probe arms, preferable application having 4 said conductive probe arms.

6. The multi-point probe according to claim 1-5, wherein said plurality of conductive probe arms have a rectangular cross section, having: the dimension of width defined as parallel to the plane of said surface of said supporting body, the dimension of depth defined as perpendicular to the plane of said surface of supporting body, the dimension of length defined as the length of said conductive probe arms extending freely from said supporting body.

7. The multi-point probe according to claim 1-6, wherein said plurality of conductive probe arms have a ratio of said length to said width within the range of 500:1 to 5:1, such as ratios 50:1 and 10:1, preferable application having the ratio of 10:1.

8. The multi-point probe according to claim 1-7, wherein said plurality of conductive probe arms have a ratio of said width to said depth within the range of 20:1 to 2:1, preferable application having the ratio of 10:1.

9. The multi-point probe according to claim 1-8, wherein said plurality of conductive probe arms have tapered distal end-points in continuation of end of said length opposing said supporting body.

10. The multi-point probe according to claim 1-8, wherein said plurality of conductive probe arms have pointed shaped distal ends in continuation of end of said length opposing said supporting body.

11. The multi-point probe according to claim 1-8, wherein said plurality of conductive probe arms have enlarged circular, elliptic or orthogonal squared distal ends in continuation of end of said length opposing said supporting body.

12. The multi-point probe according to claim 1-11, wherein said plurality of conductive probe arms have a said length in the range of 20µm to 2mm, preferably a length of 200µm.

13. The multi-point probe according to claim 1-12, wherein said plurality of conductive probe arms have a separation between distal ends of said conductive probe arms in the range of 1µm to 1mm, preferable application having said separations of 20µm, 40µm and 60µm.

14. The multi-point probe according to claim 1-13, further comprising a plurality of conductive electrodes suitable for active guarding situated between said plurality of conductive probe arms, leaving an insulating spacing between said electrodes and said conductive probe arms.

15. The multi-point probe according to claim 1-14, wherein said plurality of conductive electrodes are situated on undercut areas between said plurality of conductive probe arms on said supporting body.

16. The multi-point probe according to claim 1-14, wherein said plurality of conductive electrodes are situated on elevated areas between said plurality of conductive probe arms on said supporting body.

17. The multi-point probe according to claim 1-14, wherein said plurality of conductive electrodes are situated on co-planar areas between said plurality of conductive probe arms on said supporting body.

18. The multi-point probe according to claim 1-17, wherein supporting body is of a ceramic material.

19. The multi-point probe according to claim 1-17, wherein supporting body is of a semiconducting material.

20. The multi-point probe according to claim 19, wherein said semiconducting material comprising Ge, Si or any combinations thereof.

21. The multi-point probe according to claim 19-20, comprising:

(a) a conductive layer on top surface of said plurality of conductive probe arms; and
(b) a conductive layer acting as said electrodes on top surface of said supporting body between said plurality of conductive probe arms.

22. The multi-point probe according to claim 21, wherein said conductive layer comprising conductive materials such as Au, Ag, Pt, Ni, Ta, Ti, Cr, Cu, Os, W, Mo, Ir, Pd, Cd, Re, conductive diamond, metal suicides or any combinations thereof

23. A multi-point testing apparatus for testing electric properties on a specific location of a test sample, comprising:

(i) means for receiving and supporting said test sample;
(ii) electric properties testing means including electric generator means for generating a test signal and electric measuring means for detecting a measuring signal;
(iii) a multi-point probe, comprising:

(a) a supporting body;
(b) a plurality of conductive probe arms positioned in co-planar relationship with a surface of said supporting body, and freely extending from said supporting body, giving individually flexible motion of said plurality of conductive probe arms; and
(c) said conducting probe arms originating from a process of producing said multi-point probe including producing said conductive probe arms on supporting wafer body in facial contact with said supporting wafer body and removal of a part of said wafer body providing said supporting body and providing said conductive probe arms freely extending from said supporting body;
(d) said multi-point probe communicating with said electric properties testing means; and

(iv) reciprocating means for moving said multi-point probe relative said test sample so as to cause said conductive probe arms to be contacted with said specific location of said test sample for performing said testing of electric properties thereof.

24. The multi-point testing apparatus according to claim 23, wherein said electric properties testing means further comprising means for electric properties probing of said test sample.

25. The multi-point testing apparatus according to claim 23-24, wherein said reciprocating means further comprises holding means for said means for said multi-point probe.

26. The multi-point testing apparatus according to claim 23-25, further comprising means for positioning said holding means across said test sample and recording of a location of said holding means relative to said test sample.

27. The multi-point testing apparatus according to claim 23-26, wherein said means for positioning comprising manoeuvrability in all spatial directions, being directions coplanar to said test sample and directions perpendicular to said test sample.

28. The multi-point testing apparatus according to claim 23-27, wherein said means for positioning further comprising means for angular movement of said holding means, such as to provide angular positions for said means for said multi-point probe.

29. The multi-point testing apparatus according to claim 23-27, wherein said means for positioning further comprising means for angular movement of said holding means along an axis parallel to surface of said test sample, such as to provide angular positions for said means for said multi-point probe.

30. The multi-point testing apparatus according to claim 23-27, wherein said means for positioning further comprising means for angular movement of said holding means along an axis perpendicular to surface of said test sample, such as to provide angular positions for said means for said multi-point probe.

**31.** The multi-point testing apparatus according to claim 23-30, wherein said means for positioning further comprising means for sensing contact between said test sample and said means for said multi-point probe.

**32.** The multi-point testing apparatus according to claim 23-31, wherein said multi-point probe further includes any of the features of any of the claims 2-22.

**33.** A method of producing a multi-point probe comprising the following steps:

(i) producing a wafer body,
(ii) producing a plurality of conductive probe arms positioned in co-planar and facial relationship with said wafer body, and
(iii) removing a part of said wafer body for providing said conductive probe arms freely extending from said non-removed part of said wafer body constituting a supporting body from which said conductive probe arms extend freely.

**34.** The method according to claim 33, wherein the technique of applying the conductive probe arms in co-planar and facial relationship with the supporting wafer body, involves microfabrication technique, planar technique, CMOS technique, thick-film technique, thin-film technique or a combination thereof.

**35.** The method according to claim 33-34, the multi-point probe having any of the features of the multi-point probe according to any of the claims 1-22.

Current source          Electrometer

V

Sample

Tungsten tip

d

PRIOR ART

FIG. 1

V

I

I

Current lines

PRIOR ART

FIG. 2

FIG. 3

FIG. 4

14

14a

14b

14c

14d

16

12

**FIG. 5**

18

14

18a

s

18b

18c

18d

16

12

**FIG. 6**

FIG. 7

FIG. 8

FIG. 9

FIG. 10

European Patent
Office

**EUROPEAN SEARCH REPORT**

Application Number

EP 98 61 0023

## DOCUMENTS CONSIDERED TO BE RELEVANT

| Category | Citation of document with indication. where appropriate, of relevant passages | Relevant to claim | CLASSIFICATION OF THE APPLICATION (Int.Cl.6) |
|---|---|---|---|
| X | US 5 475 318 A (MARCUS ROBERT B ET AL) 12 December 1995 <br> * column 1, line 5 - line 14; figures 4,,5,,8B * <br> * column 3, line 6 - line 15 * <br> * column 6, line 25 - line 67 * | 1-35 | G01R1/073 |
| X,D | US 5 347 226 A (BACHMANN WALTER A ET AL) 13 September 1994 <br> * abstract; figure 15 * | 1,23,33 | |
| A | EP 0 466 274 A (IMEC INTER UNI MICRO ELECTR) 15 January 1992 <br> * column 1, line 1 - line 27 * | 1,23,33 | |
| X | PATENT ABSTRACTS OF JAPAN vol. 095, no. 011, 26 December 1995 & JP 07 199219 A (MITSUI ENG & SHIPBUILD CO LTD), 4 August 1995 <br> * abstract * | 1,23,33 | |
| X | LEE C ET AL: "HIGH-DENSITY SILICON MICROPROBE ARRAYS FOR LCD PIXEL INSPECTION" PROCEEDINGS OF THE 9TH. ANNUAL INTERNATIONAL WORKSHOP ON MICRO ELEC MECHANICAL SYSTEMS, INVESTIGATION OF MICRO STRUCTURES, SENSORS, ACTUATORS, MACHINES AND SYSTEMS. SAN DIEGO, FEB. 11 - 15, 1996, no. WORKSHOP 9, 11 February 1996, pages 429-434, XP000689309 INSTITUTE OF ELECTRICAL AND ELECTRONICS ENGINEERS <br> * abstract; figures 2,3 * | 1,23,33 | TECHNICAL FIELDS SEARCHED (Int.Cl.6) <br><br> G01R |

-/--

The present search report has been drawn up for all claims

| Place of search | Date of completion of the search | Examiner |
|---|---|---|
| BERLIN | 20 November 1998 | Fritz, S |

European Patent
Office

**EUROPEAN SEARCH REPORT**

Application Number

EP 98 61 0023

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | SOONIL HONG ET AL: "DESIGN AND FABRICATION OF A MONOLITHIC HIGH-DENSITY PROBE CARD FOR HIGH-FREQUENCY ON-WAFER TESTING" PROCEEDINGS OF THE INTERNATIONAL ELECTRON DEVICES MEETING, WASHINGTON, DEC. 3 - 6, 1989,3 December 1989, pages 289-292, XP000448223 INSTITUTE OF ELECTRICAL AND ELECTRONICS ENGINEERS * abstract; figures * * page 289, right-hand column, paragraph 1 * | 1,23,33 | |
| X | PATENT ABSTRACTS OF JAPAN vol. 013, no. 406 (P-930), 8 September 1989 & JP 01 147374 A (HITACHI LTD), 9 June 1989 * abstract * | 1,23,33 | |
| X | DE 196 48 475 A (ADVANTEST CORP) 5 June 1997 * abstract; figures * | 1,23,33 | TECHNICAL FIELDS SEARCHED (Int.Cl.6) |
| X | US 5 557 214 A (BARNETT C KENNETH) 17 September 1996 * abstract; figures * | 1,23,33 | |
| A | JP 08 015318 A (YAMAICHI ELECTRON CO LTD;OTHERS: 02) 19 January 1996 * figure 9 * | 9-11 | |

The present search report has been drawn up for all claims

| Place of search | Date of completion of the search | Examiner |
|---|---|---|
| BERLIN | 20 November 1998 | Fritz, S |

## ANNEX TO THE EUROPEAN SEARCH REPORT
## ON EUROPEAN PATENT APPLICATION NO.

EP 98 61 0023

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-1998

| Patent document cited in search report | | Publication date | Patent family member(s) | | Publication date |
|---|---|---|---|---|---|
| US 5475318 | A | 12-12-1995 | NONE | | |
| US 5347226 | A | 13-09-1994 | NONE | | |
| EP 0466274 | A | 15-01-1992 | AT | 144328 T | 15-11-1996 |
| | | | DE | 69122681 D | 21-11-1996 |
| | | | DE | 69122681 T | 06-03-1997 |
| | | | WO | 9201233 A | 23-01-1992 |
| | | | ES | 2093070 T | 16-12-1996 |
| | | | JP | 5502947 T | 20-05-1993 |
| | | | NL | 9002749 A | 03-02-1992 |
| | | | US | 5585734 A | 17-12-1996 |
| | | | US | 5369372 A | 29-11-1994 |
| DE 19648475 | A | 05-06-1997 | JP | 9148389 A | 06-06-1997 |
| US 5557214 | A | 17-09-1996 | NONE | | |
| JP 08015318 | A | 19-01-1996 | JP | 2599895 B | 16-04-1997 |

EPO FORM P0459

For more details about this annex : see Official Journal of the European Patent Office, No. 12/82